# EUROPEAN PATENT APPLICATION

(11) **EP 4 415 180 A1**
(43) Date of publication of application: **14.08.2024**
(21) Application number: 24155468.2
(22) Date of filing: 02.02.2024
(51) Int. Cl.: H01R 12/58, H01R 43/16

(54) **PRESS-FIT PIN CONFIGURATIONS FOR POWER SEMICONDUCTOR MODULES**

(30) Priority: 08.02.2023 US 202363444127 P
(71) Applicant: Infineon Technologies AG, 85579 Neubiberg (DE)
(72) Inventor: Nottelmann, Regina, 59510 Lippetal (DE); Herbrandt, Alexander, 59494 Soest (DE); Hisch, Simon, 59889 Eslohe (DE)
(74) Representative: Westphal, Mussgnug & Partner, Patentanwälte mbB

(57) **Abstract**

A press-fit pin includes: a tip part configured to guide the press-fit pin into an opening of a circuit board; a deformable part adjoining the tip part and configured to deform upon insertion into the opening of the circuit board; an elongate part adjoining the deformable part; a base part adjoining the elongate part; and an anchoring part adjoining the base part and configured for insertion into a sleeve when a force is applied to the base part. The tip part has a proximal region adjoining the deformable part and a distal region that is narrower than the proximal region. A first sidewall of the press-fit pin is sloped, with respect to a longitudinal axis of the press-fit pin, at a first acute angle in the distal region and at a second acute angle in the proximal region. The first acute angle is greater than the second acute angle.

## Description

### BACKGROUND

Power semiconductor modules having a current rating between 6A and 3600A (or higher) cover a power range from hundreds of watts to several megawatts, and have wide adoption across many applications such as general purpose drives, traction, servo-units, renewable energy applications like solar inverters or wind applications, hybrid electric and full electric vehicle applications, etc. The electrical connection interface for power semiconductor modules often includes contact pins that provide an electrical interface between the power semiconductor dies housed in the electrically insulative enclosure of the module and a circuit board with additional electronic components. One type of contact pin is a press-fit pin. The configuration of a press-fit pin controls several factors such as whether the pin is susceptible to cracking during insertion, ease of pin alignment during insertion, ampacity of the pin, etc.

### SUMMARY

According to an embodiment of a press-fit pin, the press-fit pin comprises: a tip part configured to guide the press-fit pin into an opening of a circuit board; a deformable part adjoining the tip part and configured to deform upon insertion into the opening of the circuit board; an elongate part adjoining the deformable part; a base part adjoining the elongate part; and an anchoring part adjoining the base part and configured for insertion into a sleeve when a force is applied to the base part, wherein the tip part has a proximal region adjoining the deformable part and a distal region that is narrower than the proximal region, wherein a first sidewall of the press-fit pin is sloped, with respect to a longitudinal axis of the press-fit pin, at a first acute angle in the distal region and at a second acute angle in the proximal region, wherein the first acute angle is greater than the second acute angle.

According to an embodiment of a method, the comprises: stamping sheet metal to form a plurality of press-fit pins, each press-fit pin comprising a tip part configured to guide the press-fit pin into an opening of a circuit board, a deformable part adjoining the tip part and configured to deform upon insertion into the opening of the circuit board, an elongate part adjoining the deformable part, a base part adjoining the elongate part, and an anchoring part adjoining the base part and configured for insertion into a sleeve when a force is applied to the base part, wherein the tip part has a proximal region adjoining the deformable part and a distal region that is narrower than the proximal region, wherein a first sidewall of the press-fit pin is sloped, with respect to a longitudinal axis of the press-fit pin, at a first acute angle in the distal region and at a second acute angle in the proximal region, wherein the first acute angle is greater than the second acute angle; and after the stamping, shaping edges of the tip part, the deformable part, and the anchoring part of each press-fit pin.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a side view of an embodiment of a press-fit pin.
FIG. 2 illustrates an enlarged view of a tip part of the press-fit pin.
FIG. 3 illustrates a side view of the press-fit pin, with an anchoring part of the press-fit pin inserted in a sleeve of a power semiconductor module.
FIG. 4 illustrates a top plan view of the sleeve, with the tip part and the anchoring part of the press-fit pin shown aligned with a hollow part of the sleeve.
FIG. 5 illustrates a horizontal cross-sectional view of a second (lower) region of an elongate part of the press-fit pin, taken along the line labelled A-A' in FIG. 1.
FIG. 6 illustrates a top perspective view of a power semiconductor module that uses a plurality of the press-fit pins as part of an electrical interface.
FIG. 7 illustrates a side perspective view of the power semiconductor module, after the power semiconductor module is mounted to a circuit board.
FIG. 8 illustrates a partial cross-sectional view of the circuit board.
FIG. 9 illustrates an embodiment of a method of manufacturing the press-fit pins.
FIG. 10 illustrates an embodiment of a method of inserting the press-fit pins into sleeves attached to a power semiconductor module substrate.

### DETAILED DESCRIPTION

The embodiments described herein provide configurations that yield a press-fit pin that is less susceptible to cracking, easier to align during insertion, and has increased ampacity. The term 'press-fit' as used herein refers to a pin geometry that enables plastic and/or elastic deformation in an upper region of the pin when the pin is inserted into an opening of a circuit board such as a PCB (printed circuit board) or other type of component, providing effective contact points within the contact zone. The contact radius increases due to the contact pressure since the macroscopic contact force concentrates on a small microscopic contact area. Accordingly, the pin face and the metallized face of the opening of the circuit board merge, i.e., are cold welded. Such a press-fit connection increases the effective contact zone and may provide a gas-tight contact zone that is robust against corrosive environments.

Described next, with reference to the figures, are exemplary embodiments of the press-fit pin and methods of producing the press-fit pin. Any of the press-fit pin embodiments described herein may be used interchangeably unless otherwise expressly stated.

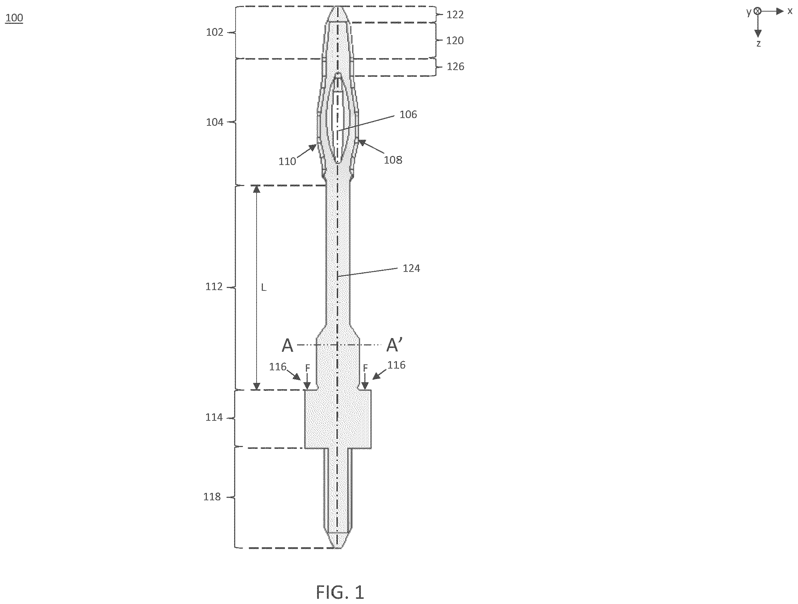

FIG. 1 illustrates a side view of an embodiment of a press-fit pin 100 for use, e.g., with power semiconductor modules. The press-fit pin 100 is metallic, i.e., made of a metal or metal alloy and may carry (power) current or a signal.

The press-fit pin 100 includes a tip part 102 configured to guide the press-fit pin 100 into an opening of a circuit board (not shown in FIG. 1). A deformable part 104 of the press-fit pin 100 adjoins the tip part 102 and is configured to plastically and/or elastically deform upon insertion into the opening of the circuit board. For example, the deformable part 104 of the press-fit pin 100 may have a central opening 106 that enables opposing sidewalls 108, 110 of the press-fit pin 100 to deform upon insertion of the deformable part 104 into the opening of the circuit board.

An elongate part 112 of the press-fit pin 100 adjoins the deformable part 104. The elongate part 112 of the press-fit pin 100 has a length 'L' that may be chosen to accommodate the thickness of a power semiconductor module housing (not shown in FIG. 1) through which the press-fit pin 100 protrudes.

A base part 114 of the press-fit pin 100 adjoins the elongate part 112. The base part 114 may be the widest part of the press-fit pin 100. Accordingly, the base part 114 can accommodate a force 'F' applied to a shoulder 116 of the press-fit pin 100 formed between the base part 114 and the elongate part 112. The shoulder 116 is configured to engage a tool (not shown in FIG. 1) that presses the press-fit pin 100 into a sleeve (not shown in FIG. 1) of a power semiconductor module.

An anchoring part 118 of the press-fit pin 100 adjoins the base part 114. The anchoring part 118 is configured for insertion into a sleeve of a power semiconductor module when a force 'F' is applied to the base part 114. The sleeve is configured to receive the anchoring part 118 of the press-fit pin 100.

The tip part 102 of the press-fit pin 100 has a proximal region 120 adjoining the deformable part 104 and a distal region 122 that is narrower than the proximal region 120. The first sidewall 108 of the press-fit pin 100 is sloped, with respect to a longitudinal axis 124 of the press-fit 100, at a first acute angle α1 in the distal region 122 of the tip part 102 and at a second acute angle α2 in the proximal region 120 of the tip part 102. The first acute angle α1 is greater than the second acute angle α2.

The second sidewall 110 of the press-fit pin 100 opposite the first sidewall 108 also may be sloped, with respect to the longitudinal axis 124 of the press-fit pin 100, at the same first acute angle (α3=α1) in the distal region 122 of the tip part 102 and at the same second acute angle (α4=α2) in the proximal region 120 of the tip part 102. The second sidewall 110 of the press-fit pin 100 may be sloped at different angles than the first sidewall 108 (α3≠α1 and/or α4≠α2) or may not be sloped but instead parallel to the longitudinal axis 124 of the press-fit pin 100 along the tip part 102. In one embodiment, the first and/or second sidewalls 108, 110 of the press-fit pin 100 may be parallel to the longitudinal axis 124 of the press-fit pin 100 along a region 126 of the deformable part 104 that adjoins the proximal region 120 of the tip part 102.

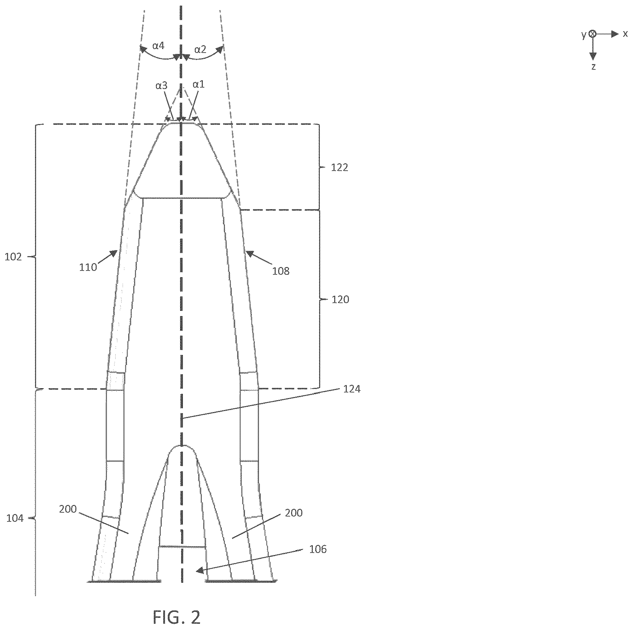

FIG. 2 illustrates an enlarged view of the tip part 102 of the press-fit pin 100, and shows the respective acute angles α1, α2, α3, α4 formed between the sidewalls 108, 110 of the press-fit pin 100 and the longitudinal axis 124 of the press-fit 100. As shown in FIGS. 1 and 2, the distal region 122 of the tip part 102 is sloped more than the proximal region 120 of the tip part 102. Such a tip configuration improves alignment of the press-fit pin 100 during insertion into a sleeve of a power semiconductor module, with the distal region 122 of the tip part 102 acting as a guide that enables more accurate alignment and therefore reception of the tip part 102 of the press-fit pin 100 by the sleeve. In one embodiment, the first and third acute angles α1 and α3 are in a range of 22.5° to 27.5° and/or the second and fourth acute angles α2 and α4 are in a range of 3.5° to 10°.

As shown in FIG. 2, the deformable part 104 of the press-fit pin 100 may have regions 200 that are more prone to cracking when the deformable part 104 is inserted into an opening of a circuit board (not shown in FIG. 2). To reduce the likelihood of cracking in these regions 200, the crack prone regions 200 may be made slightly wider (thicker). The regions of the deformable part 104 of the press-fit pin 100 immediately above the crack prone regions 200 also may be made slightly wider (thicker). However, doing so makes the deformable part 104 of the press-fit pin 100 wider which may hinder proper alignment with the corresponding circuit board opening. The sloped tip configuration shown in FIGS. 1 and 2 alleviates this alignment issue in that the more sharply sloped distal region 122 of the tip part 102 of the press-fit pin 100 acts as a guide to improve alignment accuracy, even if a wider deformable part 104 is used.

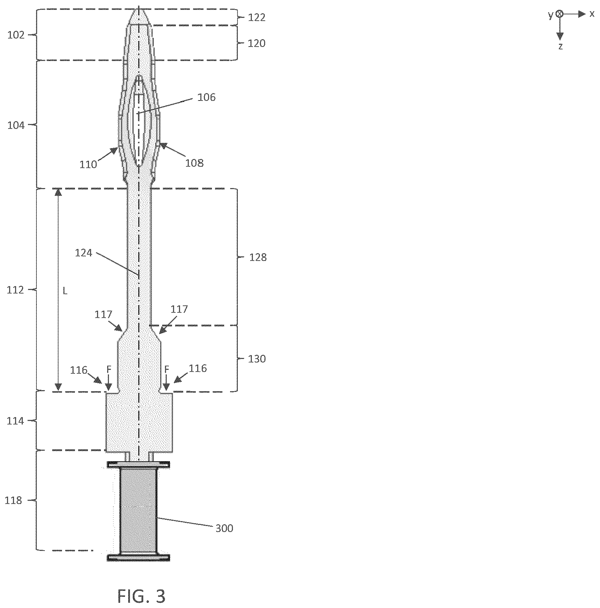

FIG. 3 illustrates a side view of the press-fit pin 100, with the anchoring part 118 of the press-fit pin 100 inserted in a sleeve 300 of a power semiconductor module. A force 'F' is applied to the base part 114 of the press-fit pin 100 to insert the anchoring part 118 in the sleeve 300. The sleeve 300 is a tubular part such as a hollow axle, hollow rivet, bushing, etc. configured to receive the anchoring part 118 of the press-fit pin 100, with a cold welded joint formed between the face of the anchoring part 118 of the press-fit pin 100 and the interior metallized face of the sleeve 300.

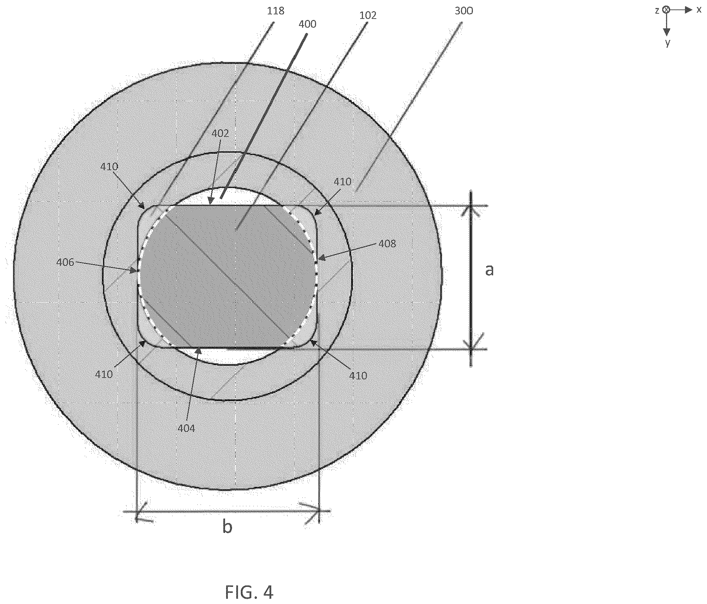

FIG. 4 illustrates a top plan view of the sleeve 300, with the tip part 102 and the anchoring part 118 of the press-fit pin 100 shown aligned with the hollow part 400 of the sleeve 300 that is configured to receive the anchoring part 118 of the press-fit pin 100. The deformable part 102, elongate part 112 and base part 114 of the press-fit pin 100 are not shown in FIG. 4 to emphasis the mating relationship between the anchoring part 118 of the press-fit pin 100 and the sleeve 300.

In FIG. 4, the anchoring part 118 of the press-fit pin 100 has a rectangular cross-sectional profile in a plane (x-y plane in FIG. 4) that is perpendicular to the longitudinal axis 124 (z axis in FIG. 4) of the press-fit pin. The hollow part 400 of the sleeve 300 may have a circular cross-sectional profile in the x-y plane as shown in FIG. 4. In this case, the sleeve 300 deforms more in the x-direction than in the y-direction in FIG. 4 when the anchoring part 118 of the press-fit pin 100 is pressed into the circular opening 400 of the sleeve 300 due to the rectangular cross-sectional profile of the anchoring part 118.

In one embodiment, a length 'b' of a first pair of opposing equal length sides 402, 404 of the rectangular cross-sectional profile for the anchoring part 118 is in a range of 1.5 to 2.5 times a length 'a' of a second pair of opposing equal length sides 406, 408 of the rectangular cross-sectional profile. Separately or in combination, the rectangular cross-sectional profile for the anchoring part 118 of the press-fit pin 100 has rounded corners 410.

In FIGS. 1 and 3, the elongate part 112 of the press-fit pin 100 has a first (upper) region 128 that adjoins the deformable part 104 of the press-fit pin 100 and a second (lower) region 130 that adjoins the base part 114 of the press-fit pin 100. The second region 130 of the elongate part 112 is wider than the first region 128 of the elongate part 112 but narrower than the base part 114. Accordingly, the base part 114 of the press-fit pin 100 can accommodate an insertion force 'F' applied to the shoulder 116 of the press-fit pin 100 formed between the base part 114 and the elongate part 112 without interference from the second region 130 of the elongate part 112.

Widening the second (lower) region 130 of the elongate part 112 of the press-fit pin 100 increases the ampacity of the press-fit pin 100. For example, each press-fit pin 100 with the wider elongate region 130 may support 50A or more. In some cases, the second (lower) region 130 of the elongate part 112 may be the hottest part of the press-fit pin 100. By widening this region 130 of the elongate part 112, the heat is better distributed and less heat is generated. Also, the number of load pins may be reduced which increases the amount of space inside the power semiconductor module for additional semiconductor chips (dies) or allows for a smaller module size. Fewer pins also improves the board attachment process and yields lower dissipation at the circuit board. Also, less material is wasted by widening the second (lower) region 130 of the elongate part 112 of the press-fit pin 100.

As explained above, the first and/or second sidewalls 108, 110 of the press-fit pin 100 may have a stepped (shoulder) profile 116 where the respective sidewall 108, 110 transitions from the second (lower) region 130 of the elongate part 112 to the base part 114. Separately or in combination, the first and/or second sidewalls 108, 110 of the press-fit pin 100 may have a slanted profile 117 where the respective sidewall 108, 110 transitions from the first (upper) region 128 of the elongate part 112 to the second (lower) region 130 of the elongate part 112.

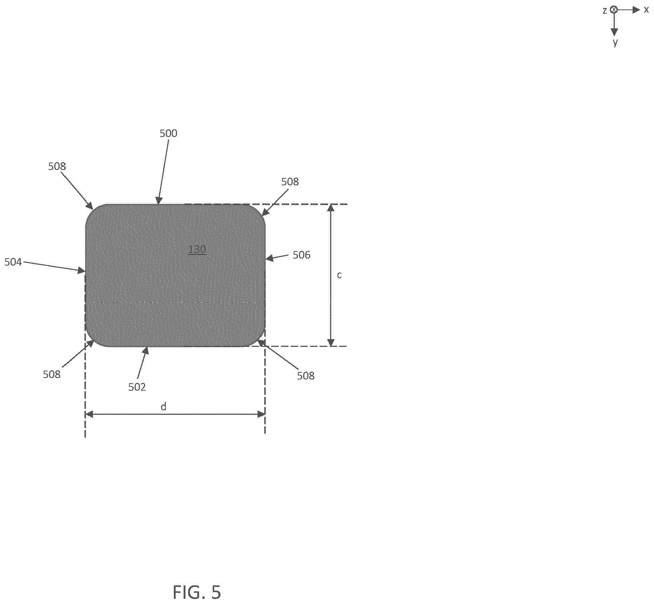

FIG. 5 illustrates a horizontal cross-sectional view of the second (lower) region 130 of the elongate part 112 of the press-fit pin 100, taken along the line labelled A-A' in FIG. 1. In FIG. 5, the second region 130 of the elongate part 112 has a rectangular cross-sectional profile in a plane (x-y plane in FIG. 4) that is perpendicular to the longitudinal axis 124 (z axis in FIG. 4) of the press-fit 100. In one embodiment, a length 'd' of a first pair of opposing equal length sides 500, 502 of the rectangular cross-sectional profile for the wider region 130 of the elongate part 112 is in a range of 1 to 1.5 times a length 'c' of a second pair of opposing equal length sides 504, 506 of the rectangular cross-sectional profile. The rectangular cross-sectional profile for the wider region 130 of the elongate part 112 of the press-fit pin 100 may have rounded corners 508.

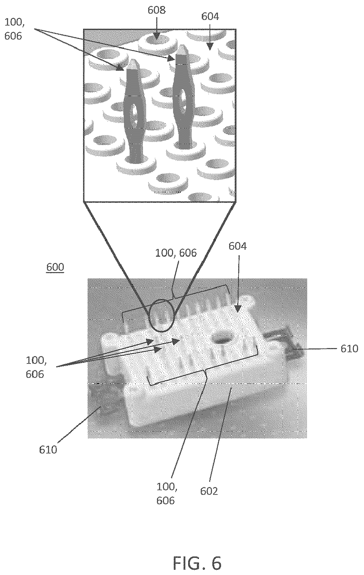

FIG. 6 illustrates a top perspective view of a power semiconductor module 600 that uses a plurality of the press-fit pins 100 as part of an electrical interface. The power semiconductor module 600 may form part of a power electronics circuit for use in various power applications such as in a DC/AC inverter, a DC/DC converter, an AC/DC converter, a DC/AC converter, an AC/AC converter, a multi-phase inverter, an H-bridge, etc. The power semiconductor module 600 includes an electrically insulative enclosure 602 such as a plastic housing. Power semiconductor dies are attached to a substrate inside the electrically insulative enclosure 602. The power semiconductor dies and substrate are out of view in FIG. 1.

The substrate may be, e.g., a DCB (direct copper bonded) substrate, an AMB (active metal brazed) substrate, an IMS (insulated metal substrate), etc. The power semiconductor dies may be power Si or SiC power MOSFET (metal-oxide-semiconductor field-effect transistor) dies, HEMT (high-electron mobility transistor) dies, IGBT (insulated-gate bipolar transistor) dies, JFET (junction filed-effect transistor) dies, etc. The power semiconductor dies may be vertical power transistor dies. For a vertical power transistor die, the primary current flow path is between the front and back sides of the die. The drain pad is typically disposed at the backside of the die, with the gate and source pads (and optionally one or more sense pads) at the frontside of the die. Additional types of semiconductor dies may be included in the power semiconductor module 600, e.g., such as one or more power diode dies, logic dies, controller dies, gate driver dies, etc.

The press-fit pins 100 are attached to the substrate and/or another structure such as a lead frame or clip frame housed within the electrically insulative enclosure 602 and protrude through a first side 604 of the electrically insulative enclosure 602 to form an electrical connection interface 606 outside the electrically insulative enclosure 602. For example, the press-fit pins 100 may extend through openings 608 in the first side 604 of the electrically insulative enclosure 602. As explained above, the first and/or second sidewalls 108, 110 of the press-fit pin 100 may have a slanted profile 117 where the respective sidewall 108, 110 transitions from the first (upper) region 128 of the elongate part 112 to the second (lower) region 130 of the elongate part 112. The slanted profile 117 may mate or interlock with a complimentary shaped reinforcing structure such as ridges formed on the underside of the electrically insulative enclosure 602.

Part of a lead frame or clip frame included in the power semiconductor module 600 may protrude through one or more side faces of the electrically insulative enclosure 602 to form a power terminal 610 of the power semiconductor module 600. The power terminal 610 may provide a reference voltage to the power semiconductor module 600 or carry current to or from the power semiconductor module 600.

The electrical connection interface 606 formed by the press-fit pins 100 provides an electrical interface to the power semiconductor dies housed in the electrically insulative enclosure 602. As explained above, the press-fit pins 100 have a pin geometry that enables plastic and/or elastic deformation of the deformable part 104 of the press-fit pin 100.

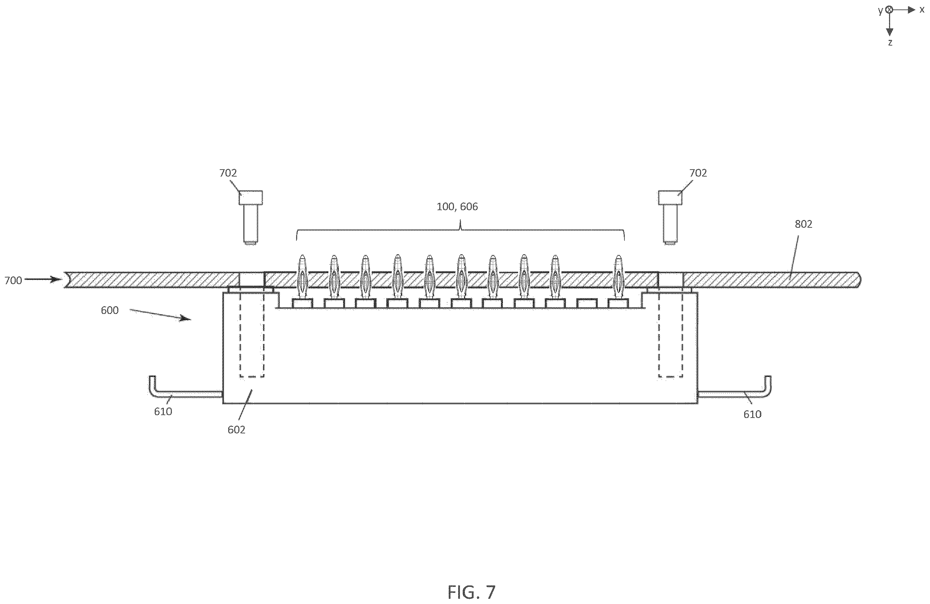

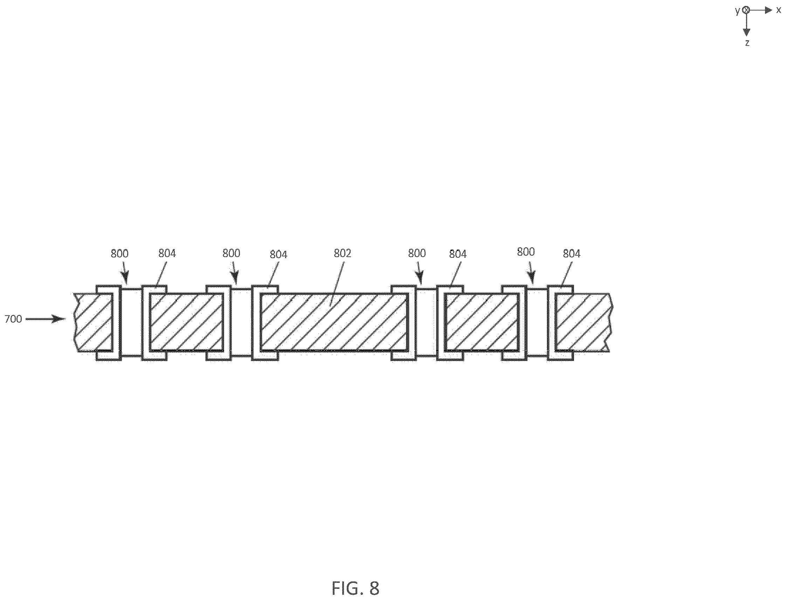

FIG. 7 illustrates a side perspective view of the power semiconductor module 600, after the power semiconductor module 600 is mounted to a circuit board 700 such as a PCB. FIG. 8 illustrates a partial cross-sectional view of the circuit board 700 designed to be mounted to the power semiconductor module 600.

Openings 800 are formed in an electrically insulating body 802 of the circuit board 700. The electrically insulating body 802 may include a pre-peg material (pre impregnated fibre) such as FR-2, FR-4, CEM-1, G-10, etc., e.g., in the case of a PCB. The openings 800 in the electrically insulating body 802 are coated or plated with a metallization 804. The press-fit pins 100 of the power semiconductor module 600 are guided into the circuit board openings 800 by the tip part 102 of the pins 100 during mounting of the circuit board 700 to the module 600. Since, as previously explained herein, the pin sidewalls 108, 110 are sloped at greater angle along the distal region 122 of the tip part 102 than along the proximal region 120 of the tip part 102, the press-fit pins 100 can be more easily aligned with and inserted into the corresponding openings 800 in the circuit board 700.

During pin insertion, contact between the deformable part 104 of each press-fit pin 100 and the circuit board metallization 804 develops, and elastic and/or plastic deformations of the press-fit pin 100 and/or the circuit board metallization 804 yield an increase contact area between the press-fit pin 100 and the circuit board metallization 804. The circuit board 700 may be mounted to the power semiconductor module 600 with the press-fit pins 100 by one or more fasteners 702 such as screws, bolts, rivets, etc., by an adhesive, by plastic welding, by clamping, etc.

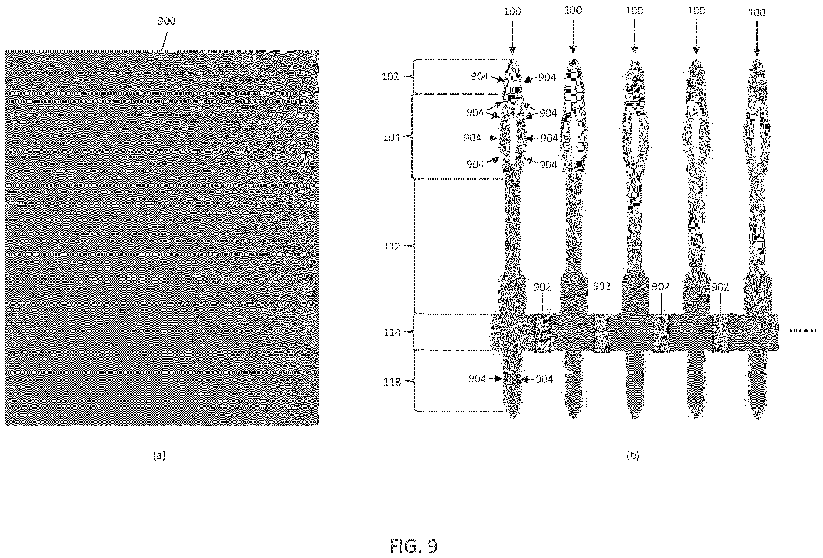

FIG. 9 illustrates an embodiment of a method of manufacturing the press-fit pins 100. In stage (a) of FIG. 9, a roll of sheet metal 900 is provided. The sheet metal 900 may comprise a metal or metal alloy, e.g., such as Cu (copper), Al (aluminium), Au (gold), etc. The sheet metal 900 may a thickness in a range of 0.002mm to 0.005mm.

In stage (b) of FIG. 9, the sheet metal 900 is stamped to define the profile of the press-fit pins 100 each of which has a contiguous construction. Excess sheet metal material is removed. The stamping die is designed such that each press-fit pin 100 has the tip part 102 configured to guide the press-fit pin 100 into an opening of a circuit board, the deformable part 104 adjoining the tip part 102 and configured to deform upon insertion into the opening of the circuit board, the elongate part 112 adjoining the deformable part 104, the base part 114 adjoining the elongate part 112, and the anchoring part 118 adjoining the base part 114 and configured for insertion into a sleeve when a force is applied to the base part 114. The stamping die is designed such that the tip part 102 has a proximal region 120 adjoining the deformable part 104 and a distal region 122 that is narrower than the proximal region 120. The stamping die is designed such that at least the first sidewall 108 of each press-fit pin 100 is sloped, with respect to the longitudinal axis 124 of the press-fit pin 100, at a first acute angle α1 in the distal region 122 and at a second acute angle α2 in the proximal region 120, with α1 > α2.

The sheet metal 900 may be stamped such that the elongate part 112 of each press-fit pin 100 has a first region 128 that adjoins the deformable part 104 and a second region 130 that adjoins the base part 114, with the second region 130 of the elongate part 112 being wider than the first region 128 of the elongate part 112 but narrower than the base part 114, e.g., as described above in connection with FIG. 3.

Separately or in combination, the sheet metal 900 may be stamped such that at least the first sidewall 108 of each press-fit pin 100 has a stepped profile 116 where the first sidewall 108 transitions from the second region 130 of the elongate part 112 to the base part 114, e.g., as described above in connection with FIG. 3.

Separately or in combination, the sheet metal 900 may be stamped such that the second (lower) region 130 of the elongate part 112 of each press-fit pin 100 has a rectangular cross-sectional profile in a plane that is perpendicular to the longitudinal axis 124 of the press-fit pin 100, e.g., as described above in connection with FIG. 5.

Separately or in combination, the sheet metal 900 may be stamped such that the anchoring part 118 of each press-fit pin 100 has a rectangular cross-sectional profile in a plane that is perpendicular to the longitudinal axis 124 of the press-fit pin 100, e.g., as described above in connection with FIG. 4. This allows for the use of relatively thin sheet metal 900, e.g. in the range of 0.002mm to 0.005mm while also accommodating sleeves 300 with circular openings 400 that are designed to accommodate a thicker pin, e.g., in the case of a conventional wire drawn pin having a square horizontal cross-section. Stamping the press-fit pins 100 to have a rectangular cross-sectional profile in the anchoring part 118 as shown in FIG. 4 enables the press-fit pins 100 to be used with sleeves 300 that are designed for square pins while still utilizing a thinner and therefore less expensive sheet metal 900 to produce the press-fit pins 100.

After the stamping, the edges 904 of one or more parts of the press-fit pits 100 may be shaped by a forming process. For example, as shown in stage (b) of FIG. 9, the edges 904 of the tip part 102, the deformable part 104, and the anchoring part 118 of each press-fit pin 100 may be rounded to avoid sharp corners, e.g., as shown in FIGS. 4 and 5.

The forming process may include embossing each press-fit pin 100 such that the rectangular cross-sectional profile for the anchoring part 118 of each press-fit pin 100 has rounded corners, e.g., as described above in connection with FIG. 4.

Separately or in combination, the forming process may include embossing each press-fit pin 100 such that the rectangular cross-sectional profile for the second (lower) region 130 of the elongate part 112 of each press-fit pin 100 has rounded corners, e.g., as described above in connection with FIG. 5.

The stamping may be performed in a single step, followed by a single forming step. After the forming, the press-fit pins 100 remain attached by a connecting region 902 of the original sheet metal 900 for easier handling. The press-fit pins 100 may be coated after the forming and separated from one another by severing / cutting along the connecting regions 902.

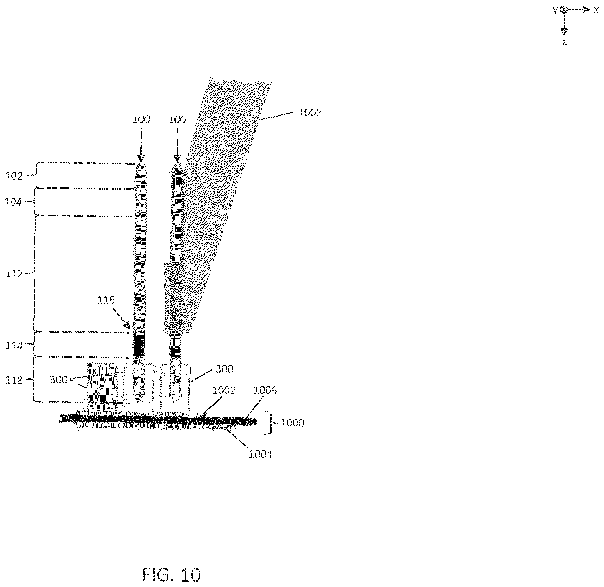

FIG. 10 illustrates an embodiment of a method of inserting the press-fit pins 100 into sleeves 300 attached to a power semiconductor module substrate 1000 such as a DCB substrate, an AMB substrate, an IMS, etc. For example, the power semiconductor module substrate 1000 may include a top metallized side 1002 separated from a bottom metallized side 1004 by an electrically insulative body 1006 such as a ceramic. The sleeves 300 are attached to the top metallized side 1002 of the power semiconductor module substrate 1000.

A tool 1008 grasps a press-fit pin 100 and presses the pin 100 into the respective sleeve 300 in the z-direction in FIG. 10. The shoulder 116 formed between the base part 114 and the elongate part 112 of the press-fit pin 100 is configured to engage the tool 1008, allowing the tool 1008 to press the press-fit pin 100 into the corresponding sleeve 300. The pressing by the tool 1008 yields a cold welded joint between the face of the anchoring part 118 of the press-fit pin 100 and the interior metallized face of the sleeve 300.

Although the present disclosure is not so limited, the following numbered examples demonstrate one or more aspects of the disclosure.

Example 1. A press-fit pin, comprising: a tip part configured to guide the press-fit pin into an opening of a circuit board; a deformable part adjoining the tip part and configured to deform upon insertion into the opening of the circuit board; an elongate part adjoining the deformable part; a base part adjoining the elongate part; and an anchoring part adjoining the base part and configured for insertion into a sleeve when a force is applied to the base part, wherein the tip part has a proximal region adjoining the deformable part and a distal region that is narrower than the proximal region, wherein a first sidewall of the press-fit pin is sloped, with respect to a longitudinal axis of the press-fit pin, at a first acute angle in the distal region and at a second acute angle in the proximal region, wherein the first acute angle is greater than the second acute angle.

Example 2. The press-fit pin of example 1, wherein the first acute angle is in a range of 22.5° to 27.5°.

Example 3. The press-fit pin of example 1, wherein the second acute angle is in a range of 3.5° to 10°.

Example 4. The press-fit pin of example 1, wherein the first acute angle is in a range of 22.5° to 27.5°, and wherein the second acute angle is in a range of 3.5° to 10°.

Example 5. The press-fit pin of any of examples 1 through 4, wherein the first sidewall of the press-fit pin is parallel to the longitudinal axis of the press-fit pin along a region of the deformable part that adjoins the proximal region of the tip part.

Example 6. The press-fit pin of any of examples 1 through 5, wherein a second sidewall of the press-fit pin opposite the first sidewall is sloped, with respect to the longitudinal axis of the press-fit pin, at the first acute angle in the distal region and at the second acute angle in the proximal region.

Example 7. The press-fit pin of any of examples 1 through 6, wherein the elongate part has a first region that adjoins the deformable part and a second region that adjoins the base part, and wherein the second region of the elongate part is wider than the first region of the elongate part but narrower than the base part.

Example 8. The press-fit pin of example 7, wherein the first sidewall of the press-fit pin has a stepped profile where the first sidewall transitions from the second region of the elongate part to the base part.

Example 9. The press-fit pin of example 7 or 8, wherein the first sidewall of the press-fit pin has a slanted profile where the first sidewall transitions from the first region of the elongate part to the second region of the elongate part.

Example 10. The press-fit pin of any of examples 7 through 9, wherein the second region of the elongate part has a rectangular cross-sectional profile in a plane that is perpendicular to the longitudinal axis of the press-fit pin.

Example 11. The press-fit pin of example 10, wherein a length of a first pair of opposing equal length sides of the rectangular cross-sectional profile is in a range of 1 to 1.5 times a length of a second pair of opposing equal length sides of the rectangular cross-sectional profile.

Example 12. The press-fit pin of example 10 or 11, wherein the rectangular cross-sectional profile has rounded corners.

Example 13. The press-fit pin of any of examples 1 through 12, wherein the anchoring part has a rectangular cross-sectional profile in a plane that is perpendicular to the longitudinal axis of the press-fit pin.

Example 14. The press-fit pin of example 13, wherein a length of a first pair of opposing equal length sides of the rectangular cross-sectional profile is in a range of 1.5 to 2.5 times a length of a second pair of opposing equal length sides of the rectangular cross-sectional profile.

Example 15. The press-fit pin of example 13 or 14, wherein the rectangular cross-sectional profile has rounded corners.

Example 16. A method of manufacturing press-fit pins, the method comprising: stamping sheet metal to form a plurality of press-fit pins, each press-fit pin comprising a tip part configured to guide the press-fit pin into an opening of a circuit board, a deformable part adjoining the tip part and configured to deform upon insertion into the opening of the circuit board, an elongate part adjoining the deformable part, a base part adjoining the elongate part, and an anchoring part adjoining the base part and configured for insertion into a sleeve when a force is applied to the base part, wherein the tip part has a proximal region adjoining the deformable part and a distal region that is narrower than the proximal region, wherein a first sidewall of the press-fit pin is sloped, with respect to a longitudinal axis of the press-fit pin, at a first acute angle in the distal region and at a second acute angle in the proximal region, wherein the first acute angle is greater than the second acute angle; and after the stamping, shaping edges of the tip part, the deformable part, and the anchoring part of each press-fit pin.

Example 17. The method of example 16, wherein the sheet metal is stamped such that the elongate part of each press-fit pin has a first region that adjoins the deformable part and a second region that adjoins the base part, and the second region of the elongate part is wider than the first region of the elongate part but narrower than the base part.

Example 18. The method of example 17, wherein the sheet metal is stamped such that the first sidewall of each press-fit pin has a stepped profile where the first sidewall transitions from the second region of the elongate part to the base part.

Example 19. The method of example 17 or 18, wherein the sheet metal is stamped such that the second region of the elongate part of each press-fit pin has a rectangular cross-sectional profile in a plane that is perpendicular to the longitudinal axis of the press-fit pin.

Example 20. The method of example 19, wherein the shaping comprises: embossing each press-fit pin such that the rectangular cross-sectional profile has rounded corners.

Example 21. The method of any of examples 16 through 20, wherein the sheet metal is stamped such that the anchoring part of each press-fit pin has a rectangular cross-sectional profile in a plane that is perpendicular to the longitudinal axis of the press-fit pin.

Example 22. The method of example 21, wherein the shaping comprises: embossing each press-fit pin such that the rectangular cross-sectional profile has rounded corners.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to include all possible conjunctive and disjunctive combinations, unless expressly noted otherwise. For example, the expression "A and/or B" should be interpreted to mean only A, only B, or both A and B. The expression "at least one of' should be interpreted in the same manner as "and/or", unless expressly noted otherwise. For example, the expression "at least one of A and B" should be interpreted to mean only A, only B, or both A and B.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A press-fit pin, comprising:
a tip part configured to guide the press-fit pin into an opening of a circuit board;
a deformable part adjoining the tip part and configured to deform upon insertion into the opening of the circuit board;
an elongate part adjoining the deformable part;
a base part adjoining the elongate part; and
an anchoring part adjoining the base part and configured for insertion into a sleeve when a force is applied to the base part,
wherein the tip part has a proximal region adjoining the deformable part and a distal region that is narrower than the proximal region,
wherein a first sidewall of the press-fit pin is sloped, with respect to a longitudinal axis of the press-fit pin, at a first acute angle in the distal region and at a second acute angle in the proximal region,
wherein the first acute angle is greater than the second acute angle.

2. The press-fit pin of claim 1, wherein at least one of
the first acute angle is in a range of 22.5° to 27.5°, and
the second acute angle is in a range of 3.5° to 10°.

3. The press-fit pin of claim 1 or 2, wherein at least one of
the first sidewall of the press-fit pin is parallel to the longitudinal axis of the press-fit pin along a region of the deformable part that adjoins the proximal region of the tip part, and
a second sidewall of the press-fit pin opposite the first sidewall is sloped, with respect to the longitudinal axis of the press-fit pin, at the first acute angle in the distal region and at the second acute angle in the proximal region.

4. The press-fit pin of any of claims 1 to 3, wherein the elongate part has a first region that adjoins the deformable part and a second region that adjoins the base part, and wherein the second region of the elongate part is wider than the first region of the elongate part but narrower than the base part.

5. The press-fit pin of claim 4, wherein one of
the first sidewall of the press-fit pin has a stepped profile where the first sidewall transitions from the second region of the elongate part to the base part, or
the first sidewall of the press-fit pin has a slanted profile where the first sidewall transitions from the first region of the elongate part to the second region of the elongate part.

6. The press-fit pin of claim 4, wherein the second region of the elongate part has a rectangular cross-sectional profile in a plane that is perpendicular to the longitudinal axis of the press-fit pin.

7. The press-fit pin of claim 6, wherein a length of a first pair of opposing equal length sides of the rectangular cross-sectional profile is in a range of 1 to 1.5 times a length of a second pair of opposing equal length sides of the rectangular cross-sectional profile.

8. The press-fit pin of claim 6, wherein the rectangular cross-sectional profile has rounded corners.

9. The press-fit pin of any of the preceding claims, wherein the anchoring part has a rectangular cross-sectional profile in a plane that is perpendicular to the longitudinal axis of the press-fit pin.

10. The press-fit pin of claim 9, wherein a length of a first pair of opposing equal length sides of the rectangular cross-sectional profile is in a range of 1.5 to 2.5 times a length of a second pair of opposing equal length sides of the rectangular cross-sectional profile.

11. A method of manufacturing press-fit pins, the method comprising:
stamping sheet metal to form a plurality of press-fit pins, each press-fit pin comprising a tip part configured to guide the press-fit pin into an opening of a circuit board, a deformable part adjoining the tip part and configured to deform upon insertion into the opening of the circuit board, an elongate part adjoining the deformable part, a base part adjoining the elongate part, and an anchoring part adjoining the base part and configured for insertion into a sleeve when a force is applied to the base part, wherein the tip part has a proximal region adjoining the deformable part and a distal region that is narrower than the proximal region, wherein a first sidewall of the press-fit pin is sloped, with respect to a longitudinal axis of the press-fit pin, at a first acute angle in the distal region and at a second acute angle in the proximal region, wherein the first acute angle is greater than the second acute angle; and
after the stamping, shaping edges of the tip part, the deformable part, and the anchoring part of each press-fit pin.

12. The method of claim 11, wherein the sheet metal is stamped such that the elongate part of each press-fit pin has a first region that adjoins the deformable part and a second region that adjoins the base part, and the second region of the elongate part is wider than the first region of the elongate part but narrower than the base part.

13. The method of claim 12, wherein the sheet metal is stamped such that the first sidewall of each press-fit pin has a stepped profile where the first sidewall transitions from the second region of the elongate part to the base part.

14. The method of claim 12, wherein the sheet metal is stamped such that the second region of the elongate part of each press-fit pin has a rectangular cross-sectional profile in a plane that is perpendicular to the longitudinal axis of the press-fit pin.

15. The method of claim 11, wherein the sheet metal is stamped such that the anchoring part of each press-fit pin has a rectangular cross-sectional profile in a plane that is perpendicular to the longitudinal axis of the press-fit pin.
